# EUROPEAN PATENT SPECIFICATION

(11) **EP 3 225 714 B1**
(45) Date of publication and mention of the grant of the patent: **18.10.2023**
(21) Application number: 17163632.7
(22) Date of filing: 29.03.2017
(51) Int. Cl.: C23C 8/02, C23C 8/06, C23C 8/08, C23C 26/00, B05D 5/08, B05D 7/14, C23C 16/46, C23C 16/54, B32B 15/04, B32B 15/18, B32B 15/20, C23C 16/30, C22C 19/05, C22C 21/08, C22C 38/00, C22C 38/42, C22C 38/44, C22C 38/46, C22C 38/58

(54) **TREATED ARTICLE AND SYSTEMS HAVING THE TREATED ARTICLE**
BEHANDELTER ARTIKEL UND SYSTEME MIT DEM BEHANDELTEN ARTIKEL
ARTICLE TRAITÉ ET SYSTÈMES AYANT CET ARTICLE TRAITÉ

(30) Priority: 29.03.2016 US 201662314488 P
(43) Date of publication of application: 04.10.2017
(73) Proprietor: Silcotek Corp., Bellefonte, Pennsylvania 16823 (US)
(72) Inventor: SMITH, David A., Bellefonte, PA Pennsylvania 16823 (US)
(74) Representative: Wallin, Nicholas James

(56) References cited:
- EP-A2- 1 150 345
- WO-A1-2010/125926
- WO-A2-2014/011251
- JP-A- 2013 227 628
- US-A1- 2014 370 300

## Description

### FIELD OF THE INVENTION

The present invention is directed to treated articles.

### BACKGROUND OF THE INVENTION

The formation of coke and fouling of metal and metallic substrates causes significant system performance loss, economic loss, and irreparable physical damage. Fouling results from an undesirable accumulation of materials on a surface that can impact operational features of such substrates. Coking is an undesirable formation and accumulation of carbonaceous deposits on a surface. Coking and fouling of a surface can impact heat transfer properties, cause blockages in tubes/pipes, create flow instability in tubes/pipes, impact vibrational properties, lead to corrosion, and/or cause many other types of problems.

There are known techniques to provide a level of anticoking. For example, US Pat. No. 6,337,459, describes a multi-layer approach to provide some anticoking character to a surface. The approach relies upon a surface layer being welded to a metal substrate material. The surface layer includes, by weight, 36-49% chromium, 35-63% nickel, and 0.5-5% molybdenum. Silicon and carbon are considered by the mentioned document here above as being undesirable impurities, with carbon being at a concentration of no more than 0.1%, by weight, and silicon being at a concentration of no more than 0.3%, by weight. Fluorine is not present in the surface layer. In environments exposed to a variety of temperatures, such use of a metal surface layer on a metal substrate can be undesirably limiting based upon differences in coefficients of thermal expansion, which can lead to fatigue, delamination, or other issues with welded materials.

Enhancing materials with coatings or films containing carbon, silicon, and fluorine is known. Such coatings or films can provide improvements, but are subject to adhesion limitations, can be limited in applicability due to coating process conditions (for example, temperature requirements), and/or can require use of undesirable chemicals (for example, pyrophoric gases, toxic materials, and/or hazardous materials).

For example, as described in the patent document EP 0352061, carbon, silicon, and fluorine have been applied to surfaces through sputtering to achieve enhanced properties. Similarly, US Pat. No. 6,592,993, describes fluorinating diamondlike-carbon that is positioned on glass. US Pat. Application Pub. No. 2016/0049309, describes fluorinating a silicon wafer through plasma enhanced chemical vapor deposition. US Pat. No. 6,444,268, describes halogenating polymers, silica, ceramics, and glass.

Each of these above-mentioned references is directed to a field that does not involve metal or metallic surfaces and, thus, does not solve antifouling and/or anticoking issues for metal and metallic substrates. The references also have other drawbacks. The sputtering techniques in the patent document 0352061 and the plasma enhanced chemical vapor deposition techniques in US Pat. Application Pub. No. 2016/0049309 are limited to line-of-site techniques. The halogenated polymers described in US Pat. No. 6,444,268, are limited in applicability based upon thermal limitations.

There are techniques using fluorine in conjunction with metal or metallic substrates. US Pat. No. 5,141,567, describes adding fluorine to steel as an intermediate during a nitriding process. In such processes, the fluorine does not remain part of the steel and is only present until subsequent process steps are employed. As such, the nitriding process does not solve antifouling and/or anticoking issues for metal and metallic substrates.

Patent documents US2014 370300A1, WO2010125926A1 and JP2013227628A deals with the problem of providing articles with antifouling surfaces by applying a treatment to the surface of the article.

Treated articles and processes of producing the treated articles, systems having treated articles, and processes incorporating treated articles that improve upon one or more of the above drawbacks would be desirable in the art.

### BRIEF DESCRIPTION OF THE INVENTION

In the present invention, a treated article includes a metal or metallic article according to the appended claim 1.

In another embodiment, a system includes a flow path, a treated article having a metal or metallic substrate, and a surface treatment of the metal or metallic substrate, the surface treatment having fluorine, silicon, and carbon. The surface treatment is within the flow path of the system.

In another embodiment, a process includes flowing a fluid through a flow path. A surface treatment is within the flow path, and the surface treatment is within a treated article having a metal or metallic substrate, the surface treatment having fluorine, silicon, and carbon.

Other features and advantages of the present invention will be apparent from the following more detailed description, taken in conjunction with the accompanying drawings which illustrate, by way of example, the principles of the invention.

### BRIEF DESCRIPTION OF THE DRAWINGS

FIG. 1 is a perspective view with an enlarged section of a treated component, according to an embodiment of the disclosure.
FIG. 2 is a schematic view showing a treated component within an intake and exhaust system, for example, of an automobile, according to an embodiment of the disclosure.
FIG. 3 is a schematic view showing a treated component within a fuel injection system, for example, of an automobile, according to an embodiment of the disclosure.
FIG. 4 is a schematic view showing treated components within an exhaust gas recirculation system, for example, of an automobile, according to embodiments of the disclosure.
FIG. 5 is a schematic view showing treated components within an exhaust gas recirculation system, for example, of an automobile, according to embodiments of the disclosure.
FIG. 6 is a schematic sectioned view showing a combustion system, for example, an engine of an air plane, according to an embodiment of the disclosure.
FIG. 7 is a schematic perspective view showing a treated component within a heating, ventilation, air conditioning, and refrigeration system (HVAC&R system), according to an embodiment of the disclosure.
FIG. 8 is a perspective view showing a treated component with a honeycomb arrangement, for example, in a heat transfer system, according to an embodiment of the disclosure.
FIG. 9 is a perspective view showing a treated component with stacked plates, for example, in a heat transfer system, according to an embodiment of the disclosure.
FIG. 10 is a perspective view showing a treated component with one or more fins, for example, in a heat transfer system, according to an embodiment of the disclosure.
FIG. 11 is a perspective cutaway view showing a treated component with one or more tubes, for example, in a heat transfer system, according to an embodiment of the disclosure.

Wherever possible, the same reference numbers will be used throughout the drawings to represent the same parts.

### DETAILED DESCRIPTION OF THE INVENTION

Provided are treated articles as defined by the appended claims and processes of producing the treated articles, systems having treated articles, and processes incorporating treated articles according to the appended claims.

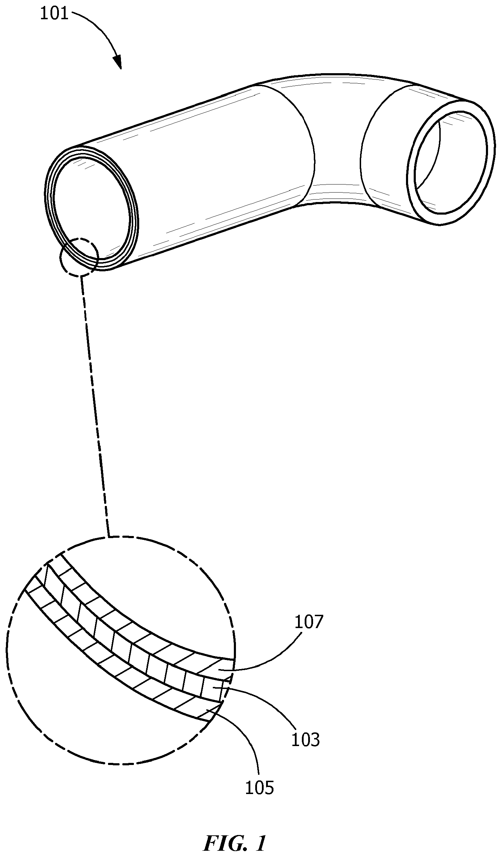

Referring to FIG. 1, a treated article 101 includes a metal or metallic substrate 103 with a surface treatment capable of being on and/or within an external surface 105 and/or an internal surface 107 of the metal or metallic substrate 103. The surface treatment has fluorine, silicon, and carbon and is capable of withstanding temperatures of at least 100°C (for example, greater than 200°C, greater than 300°C, greater than 400°C, greater than 500°C, greater than 600°C, or any suitable combination, sub-combination, range, or sub-range therein). The surface treatment imparts molecules with carbon-fluorine bonds and silicon-oxygen bonds detectable through infrared spectroscopy.

The surface treatment is detectable through contact angle measurement and/or thermal oxidation measurement. Prior to thermal oxidation, the surface treatment has a water contact angle within the range between 120° and 121° on 304 stainless steel, and between 125° and 126° on 316 stainless steel. Additionally or alternatively, prior to thermal oxidation, the surface treatment has a hexadecane contact angle within the range of between 77° and 78° on 304 stainless steel and between 75° and 76° on 316 stainless steel.

The surface treatment is detectable based upon thermal oxidation properties, for example, at 300°C in air (or another 70% to 75% oxygen environment). The contact angle of the surface treatment under such thermal oxidation increases for a period of at least 1 hour of thermal oxidation, a period of at least 2 hours of thermal oxidation, or any suitable combination, sub-combination, range, or sub-range therein. The contact angle under such thermal oxidation stays within a range over a period of at least 3 hours, at least 4 hours, or up to 70 hours. Such ranges include between 77° and 81° for a hexadecane contact angle on 304 stainless steel and between 75° and 85° for a hexadecane contact angle on 316 stainless steel and 120° and 133° for a water contact angle on 304 stainless steel and 125° and 135° for a water contact angle on 316 stainless steel.

The surface treatment is imparted by introduction of a fluorine-silicon-carbon-containing gas within a pressure range and a temperature range for a duration of time during one or more steps in an enclosed chamber and/or vessel. Use of the term "enclosed" is intended to encompass static techniques and differentiate from constant flow techniques, such as, plasma enhance chemical vapor deposition. Suitable dimensions for the enclosed chamber and/or the vessel include, but are not limited to, having a minimum width of greater than 5 cm, greater than 10 cm, greater than 20 cm, greater than 30 cm, greater than 100 cm, greater than 300 cm, greater than 1,000 cm, between 10 cm and 100 cm, between 100 cm and 300 cm, between 100 cm and 1,000 cm, between 300 cm and 1,000 cm, any other minimum width capable of uniform or substantially uniform heating, or any suitable combination, sub-combination, range, or sub-range therein. In some embodiments, much larger dimensions are present, for example, on the order of meters.

Suitable volumes for the chamber and/or the vessel include, but are not limited to, greater than 1,000 cm³, greater than 3,000 cm³, greater than 5,000 cm³, greater than 10,000 cm³, greater than 20,000 cm³, between 3,000 cm³ and 5,000 cm³, between 5,000 cm³ and 10,000 cm³, between 5,000 cm³ and 20,000 cm³, between 10,000 cm³ and 20,000 cm³, any other volumes capable of uniform or substantially uniform heating, or any suitable combination, sub-combination, range, or sub-range therein. In some embodiments, much larger dimensions are present, for example, on the order of cubic meters.

The introducing of the fluorine-silicon-carbon-containing gas within the pressure range and the temperature range for the duration of time during the one or more steps results in constituents of the fluorine-silicon-carbon-containing gas; the fluorine, the silicon, and the carbon, being within the metal or metallic substrate 103 The fluorine-silicon-carbon-containing gases for imparting the constituents include, an organofluorotrialkoxysilane, an organofluorosilylhydride, an organofluoro silyl, and/or tridecafluoro 1,1,2,2-tetrahydrooctylsilane.

In one embodiment, the pressure range for the introducing of the fluorine-silicon-carbon-containing gas is between 0.07 to 1379 MPa, 7.9 to 689.5 MPa, 34.5 to 275.80 MPa, 137.90 to 172.37 MPa , less than 137.90 MPa, less than 103.4 MPa, 6.90 MPA, 34.47 MPa, 158.58 MPa, 172.37 MPa, 275.79 MPa, 689.47 MPa, 1378.95 MPa or any suitable combination of ranges above ( 0.01 psia and 200 psia, between 1.0 psia and 100 psia, between 5 psia and 40 psia, between 20 psia and 25 psia, greater than 25 psia, greater than 20 psia, less than 20 psia, less than 15 psia, 1.0 psia, 5 psia, 20 psia, 23 psia, 25 psia, 40 psia, 100 psia, 200 psia, or any suitable combination, sub-combination, range, or sub-range therein).

In one embodiment, the temperature range for the introducing of the fluorine-silicon-carbon-containing gas is between 100 °C and 700 °C, between 100 °C and 450 °C, between 100 °C and 300 °C, between 200 °C and 500 °C, between 300 °C and 600 °C, between 450 °C and 700 °C, 700 °C, 450 °C, 100 °C, between 200 °C and 600 °C, between 300 °C and 600 °C, between 400 °C and 500 °C, 300 °C, 400 °C, 500 °C, 600 °C, or any suitable combination, sub-combination, range, or sub-range thereof.

In one embodiment, the duration of time for the introducing of the fluorine-silicon-carbon-containing gas is at least 10 minutes, at least 1 hour, at least 2 hours, at least 3 hours, at least 4 hours, at least 5 hours, at least 7 hours, at least 10 hours, between 10 minutes and 24 hours, between 1 hour and 10 hours, between 1 hour and 5 hours, between 1 hour and 4 hours, between 2 hours and 10 hours, between 4 hours and 6 hours, between 4 hours and 8 hours, between 4 hours and 10 hours, between 6 hours and 8 hours, less than 10 hours, less than 8 hours, less than 6 hours, less than 4 hours, or any suitable combination, sub-combination, range, or sub-range therein.

The one or more steps of introducing of the fluorine-silicon-carbon-containing gas includes one cycle, two cycles, three cycles, four cycles, or more than four cycles preceded by or followed by other steps, such as, heating steps and/or oxidation steps that are concurrent or sequential. For example, in one embodiment, the surface treatment includes an oxidation step prior to the introducing of the fluorine-silicon-carbon-containing gas. The oxidation step(s) includes exposure to any suitable chemical species capable of donating a reactive oxygen species into the coating under predetermined oxidation conditions.

The oxidation step is capable of being achieved by exposure to water (alone, with zero air, or with an inert gas), oxygen (for example, at a concentration, by weight, of at least 50%), air (for example, alone, not alone, and/or as zero air), nitrous oxide, ozone, peroxide, or a combination thereof. As used herein, the term "zero air" refers to atmospheric air having less than 0.1 ppm total hydrocarbons. The term "air" generally refers to a gaseous fluid, by weight, of mostly nitrogen, with the oxygen being the second highest concentration species within. For example, in one embodiment, the nitrogen in the oxidation step is present at a concentration, by weight, of at least 70% (for example, between 75% and 76%) and oxygen is present at a concentration, by weight, of at least 20% (for example, between 23% and 24%).

In one embodiment, the oxidation step is with water as an oxidizing agent (for example, within a temperature range of between 25 °C and 600 °C, a temperature range of between 300 °C and 600 °C, or at a temperature of 450 °C). In one embodiment, the oxidation step is with air and water (for example, within a temperature range of between 100 °C and 600 °C, a temperature range of 300 °C to 600 °C, or at a temperature of 450 °C). In one embodiment, the oxidation step is only with air (for example, within a temperature range of between 100 °C and 600 °C, a temperature range of between 300 °C and 600 °C, or at a temperature of 450 °C). In one embodiment, the oxidation step is with nitrous oxide (N₂O). Specifically, N₂O is applied under heat (for example, about 450 °C) with a pressure of substantially pure N₂O in a vessel with carbosilane-coated samples.

Other suitable steps to precede or follow the introducing of the fluorine-silicon-carbon-containing gas include purging, cleaning, and/or heating the chamber and/or the vessel. In one embodiment, the purging evacuates or substantially evacuates gas(es) from the chamber and/or the vessel by selectively applying a purge gas. Suitable purge gases are nitrogen, helium, argon, or any other inert gas. The purging is in one purge cycle, two purge cycles, three purge cycles, more than three purge cycles, or any suitable number of purge cycles that permits the chamber and/or the vessel to be a chemically inert environment.

In one embodiment, the cleaning removes undesirable materials from the metal or metallic substrate 103. The cleaning includes any suitable technique for removing materials that may volatilize in the higher temperatures of the enclosed chamber and/or vessel or that may inhibit the ability for the surface treatment to impart the fluorine, silicon, and carbon.

In one embodiment, the heating is from a lower temperature of the fluorine-silicon-carbon-containing gas to a higher temperature of the fluorine-silicon-carbon-containing gas. Depending upon the species of the fluorine-silicon-carbon-containing gas utilized, suitable temperatures include, but are not limited to, less than 30 °C, less than 60 °C, less than 100 °C, less than 150 °C, less than 200 °C, less than 250 °C, less than 300 °C, less than 350 °C, less than 400 °C, less than 440 °C, less than 450 °C, between 100 °C and 300 °C, between 125 °C and 275 °C, between 200 °C and 300 °C, between 230 °C and 270 °C, or any suitable combination, sub-combination, range, or sub-range therein.

Suitable metal or metallic substrates 103 austenitic stainless steels. Prior to the treatment, the metal or metallic substrate 103 is devoid or substantially devoid of fluorine.

The metal or metallic substrate 103 is or includes a composition, by weight, of up to 0.08% carbon, between 18% and 20% chromium, up to 2% manganese, between 8% and 10.5% nickel, up to 0.045% phosphorus, up to 0.03% sulfur, up to 1% silicon, and a balance of iron (for example, between 66% and 74% iron).

Alternatively, the metal or metallic substrate 103 is or includes a composition, by weight, of up to 0.08% carbon, up to 2% manganese, up to 0.045% phosphorus, up to 0.03% sulfur, up to 0.75% silicon, between 16% and 18% chromium, between 10% and 14% nickel, between 2% and 3% molybdenum, up to 0.1% nitrogen, and a balance of iron.

In one embodiment, the metal or metallic substrate 103 is or includes a composition, by weight, of up to 0.03% carbon, up to 2% manganese, up to 0.045% phosphorus, up to 0.03% sulfur, up to 0.75% silicon, between 16% and 18% chromium, between 10% and 14% nickel, between 2% and 3% molybdenum, up to 0.1% nitrogen, and a balance of iron.

In one embodiment not part of the present invention, the metal or metallic substrate 103 is or includes a composition, by weight, of between 14% and 17% chromium, between 6% and 10% iron, between 0.5% and 1.5% manganese, between 0.1% and 1% copper, between 0.1% and 1% silicon, between 0.01% and 0.2% carbon, between 0.001% and 0.2% sulfur, and a balance nickel (for example, 72%).

In one embodiment not part of the present invention, the metal or metallic substrate 103 is or includes a composition, by weight, of between 20% and 24% chromium, between 1% and 5% iron, between 8% and 10% molybdenum, between 10% and 15% cobalt, between 0.1% and 1% manganese, between 0.1% and 1% copper, between 0.8% and 1.5% aluminum, between 0.1% and 1% titanium, between 0.1% and 1% silicon, between 0.01% and 0.2% carbon, between 0.001% and 0.2% sulfur, between 0.001% and 0.2% phosphorus, between 0.001% and 0.2% boron, and a balance nickel (for example, between 44.2% and 56%).

In one embodiment not part of the present invention the metal or metallic substrate 103 is or includes a composition, by weight, of between 20% and 23% chromium, between 4% and 6% iron, between 8% and 10% molybdenum, between 3% and 4.5% niobium, between 0.5% and 1.5% cobalt, between 0.1% and 1% manganese, between 0.1% and 1% aluminum, between 0.1% and 1% titanium, between 0.1% and 1% silicon, between 0.01% and 0.5% carbon, between 0.001% and 0.02% sulfur, between 0.001% and 0.02% phosphorus, and a balance nickel (for example, 58%).

One embodiment not part of the present invention, the metal or metallic substrate 103 is or includes a composition, by weight, of between 25% and 35% chromium, between 8% and 10% iron, between 0.2% and 0.5% manganese, between 0.005% and 0.02% copper, between 0.01% and 0.03% aluminum, between 0.3% and 0.4% silicon, between 0.005% and 0.03% carbon, between 0.001% and 0.005% sulfur, and a balance nickel (for example, 59.5%).

In one embodiment not part of the present invention the metal or metallic substrate 103 is or includes a composition, by weight, of between 17% and 21%, between 2.8% and 3.3%, between 4.75% and 5.5% niobium, between 0.5% and 1.5% cobalt, between 0.1% and 0.5% manganese, between 0.2% and 0.8% copper, between 0.65% and 1.15% aluminum, between 0.2% and 0.4% titanium, between 0.3% and 0.4% silicon, between 0.01% and 1% carbon, between 0.001 and 0.02% sulfur, between 0.001 and 0.02% phosphorus, between 0.001 and 0.02% boron, and a balance nickel (for example, between 50% and 55%).

In one embodiment not part of the present invention, the metal or metallic substrate 103 is or includes a composition, by weight, of between 2% and 3% cobalt, between 15% and 17% chromium, between 5% and 17% molybdenum, between 3% and 5% tungsten, between 4% and 6% iron, between 0.5% and 1% silicon, between 0.5% and 1.5% manganese, between 0.005 and 0.02% carbon, between 0.3% and 0.4% vanadium, and a balance nickel.

In one embodiment not part of the present invention, the metal or metallic substrate 103 is or includes a composition, by weight, of up to 0.15% carbon, between 3.5% and 5.5% tungsten, between 4.5% and 7% iron, between 15.5% and 17.5% chromium, between 16% and 18% molybdenum, between 0.2% and 0.4% vanadium, up to 1% manganese, up to 1% sulfur, up to 1% silicon, up to 0.04% phosphorus, up to 0.03% sulfur, and a balance nickel.

In one embodiment not part of the present invention, the metal or metallic substrate 103 is or includes a composition, by weight, of up to 2.5% cobalt, up to 22% chromium, up to 13% molybdenum, up to 3% tungsten, up to 3% iron, up to 0.08% silicon, up to 0.5% manganese, up to 0.01% carbon, up to 0.35% vanadium, and a balance nickel (for example, 56%).

In one embodiment not part of the present invention, the metal or metallic substrate 103 is or includes a composition, by weight, of between 1% and 2% cobalt, between 20% and 22% chromium, between 8% and 10% molybdenum, between 0.1% and 1% tungsten, between 17% and 20% iron, between 0.1% and 1% silicon, between 0.1% and 1% manganese, between 0.05 and 0.2% carbon, and a balance nickel.

In one embodiment not part of the present invention, the metal or metallic substrate 103 is or includes a composition, by weight, of between 0.01% and 0.05% boron, between 0.01% and 0.1% chromium, between 0.003% and 0.35% copper, between 0.005% and 0.03% gallium, between 0.006% and 0.8% iron, between 0.006% and 0.3% magnesium, between 0.02% and 1% silicon + iron, between 0.006% and 0.35% silicon, between 0.002% and 0.2% titanium, between 0.01% and 0.03% vanadium + titanium, between 0.005% and 0.05% vanadium, between 0.006% and 0.1% zinc, and a balance aluminum (for example, greater than 99%).

In one embodiment not part of the present invention, the metal or metallic substrate 103 is or includes a composition, by weight, of between 0.05% and 0.4% chromium, between 0.03% and 0.9% coper, between 0.05% and 1% iron, between 0.05% and 1.5% magnesium, between 0.5% and 1.8% manganese, between 0.5% and 0.1% nickel, between 0.03% and 0.35% titanium, up to 0.5% vanadium, between 0.04% and 1.3% zinc, and a balance aluminum (for example, between 94.3% and 99.8%).

In one embodiment not part of the present invention, the metal or metallic substrate 103 is or includes a composition, by weight, of between 0.0003% and 0.07% beryllium, between 0.02% and 2% bismuth, between 0.01% and 0.25% chromium, between 0.03% and 5% copper, between 0.09% and 5.4% iron, between 0.01% and 2% magnesium, between 0.03% and 1.5% manganese, between 0.15% and 2.2% nickel, between 0.6% and 21.5% silicon, between 0.005% and 0.2% titanium, between 0.05% and 10.7% zinc, and a balance aluminum (for example, between 70.7% to 98.7%).

In one embodiment not part of the present invention, the metal or metallic substrate 103 is or includes a composition, by weight, of between 0.15% and 1.5% bismuth, between 0.003% and 0.06% boron, between 0.03% and 0.4% chromium, between 0.01% and 1.2% copper, between 0.12% and 0.5% chromium + manganese, between 0.04% and 1% iron, between 0.003% and 2% lead, between 0.2% and 3% magnesium, between 0.02% and 1.4% manganese, between 0.05% and 0.2% nickel, between 0.5% and 0.5% oxygen, between 0.2% and 1.8% silicon, up to 0.05% strontium, between 0.05% and 2% tin, between 0.01% and 0.25% titanium, between 0.05% and 0.3% vanadium, between 0.03% and 2.4% zinc, between 0.05% and 0.2% zirconium, between 0.150 and 0.2% zirconium + titanium, and a balance of aluminum (for example, between 91.7% and 99.6%).

In one embodiment not part of the present invention, the metal or metallic substrate 103 is or includes a composition, by weight, of between 0.4% and 0.8% silicon, up to 0.7% iron, between 0.15% and 0.4% copper, up to 0.15% manganese, between 0.8% and 1.2% magnesium, between 0.04% and 0.35% chromium, up to 0.25% zinc, up to 0.15% titanium, optional incidental impurities (for example, at less than 0.05% each, totaling less that 0.15%), and a balance of aluminum (for example, between 95% and 98.6%).

In one embodiment not part of the present invention, the metal or metallic substrate 103 is or includes a composition, by weight, of between 11% and 13% silicon, up to 0.6% impurities/residuals, and a balance of aluminum.

The treated article 101 having the metal or metallic substrate 103 with the surface treatment (for example, on and/or within the external surface 105 and/or the internal surface 107 of the metal or metallic substrate 103) is capable of having a geometry and/or structure, such as, but not limited to, being tubular, being planar, being non-planar, being of complex geometry, being angled, being straight, being bent, being coiled, being layered, being interwoven, being stacked, being rigid, being flexible, being drilled, being cut, being etched, being sintered, being ground, being polished (mechanically or electrochemically), being cast, being forged, being molded, being additively produced, being tempered, being non-tempered, having equiaxed grain structure, having directionally-solidified or columnar grain structure, having single crystal grain structure, having a single material, having multiple materials (for example, by being joined or welded), or a suitable combination thereof.

In some embodiments, the treated article 101 is one or more of fittings (for example, unions, connectors, adaptors, other connections between two or more pieces of tubing, for example, capable of making a leak-free or substantially leak-free seal), compression fittings (including ferrules, such as, a front and back ferrule), tubing (for example, coiled tubing, tubing sections such as used to connect a sampling apparatus, pre-bent tubing, straight tubing, loose wound tubing, tightly bound tubing, and/or flexible tubing), valves (such as, gas sampling, liquid sampling, transfer, shut-off, or check valves, for example, including a rupture disc, stem, poppet, rotor, multi-position configuration, able to handle vacuum or pressure, a handle or stem for a knob, ball-stem features, ball valve features, check valve features, springs, multiple bodies, seals, needle valve features, packing washers, and/or stems), quick-connects, sample cylinders, regulators and/or flow-controllers (for example, including o-rings, seals, and/or diaphragms), injection ports (for example, for gas chromatographs), in-line filters (for example, having springs, sintered metal filters, mesh screens, and/or weldments), glass liners, gas chromatograph components, liquid chromatography components, components associated with vacuum systems and chambers, components associated with analytical systems, sample probes, control probes, downhole sampling containers, drilled and/or machined block components, manifolds, or a combination thereof.

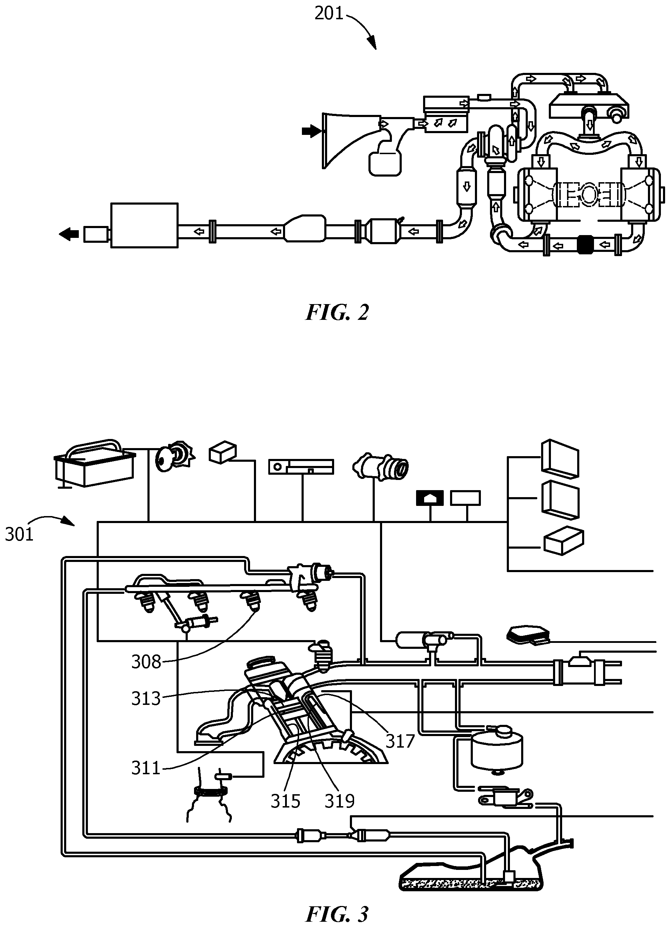

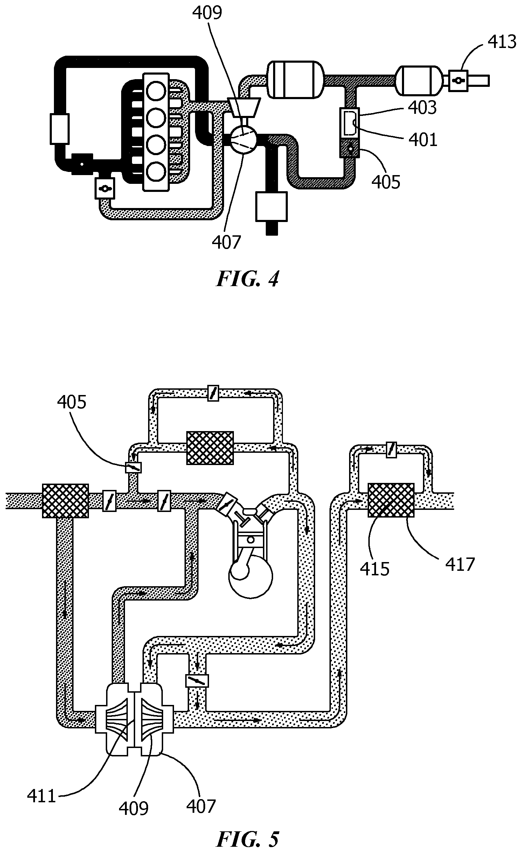

Additionally or alternatively, in some embodiments, the treated article 101 is a portion of a system. For example, referring to FIG. 2, in one embodiment, the treated article 101 is an intake and/or exhaust system 201 for an internal combustion engine or a portion thereof, for example, configured to use gasoline (see FIG. 2) or diesel (see FIGS. 4-5). Referring to FIGS. 4 and 5, in one embodiment, the treated article 101 is an exhaust gas recirculation cooler block 401, the exhaust gas recirculation cooler block housing 403, the exhaust gas recirculation cooler valves 405, turbocharger housing 407, turbocharger compressor housing 409, turbocharger plates and components 411, exhaust valves 413, particulate filters 415, particulate filter housings 417, urea injection system and components, or other suitable portions thereof.

Referring to FIG. 3, in one embodiment, the treated component 101 is a fuel injection system 301, or a portion of the fuel injection system 301, such as, fuel injector nozzles 305 (and, in some embodiments, fuel injector tips and/or fuel injector needles), pistons 311, piston heads 313, piston sleeves 315, fuel injection and exhaust valves 317, fuel injection and exhaust valve seats 319, and/or other suitable components.

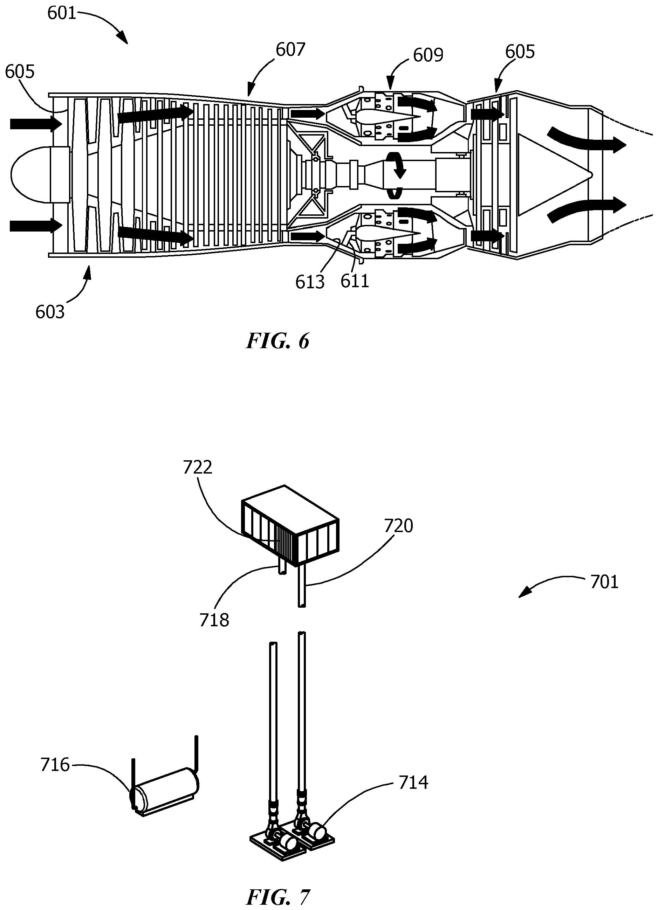

Referring to FIG. 6, in one embodiment, the treated component 103 is a combustion system 601 (for example, an engine or a vehicle, such as, an airplane or automobile, or a power generation turbine). In further embodiments, the treated component 103 is positioned within an air intake region 603 (for example, at least partially defining an air inlet 605), a compression region 607, a combustion region 609 (for example, at least partially defining a combustion chamber 611, fuel supply paths 613, or other combustion-related features), a turbine region 613 (for example, at least partially defining components, such as, blades/buckets, air foils, fins, angel wings, shrouds, dovetails, and/or platforms), an exhaust region 615, and/or other suitable components (for example, valves, flaps, plates, chambers, tubing, and/or fittings).

Referring to FIG. 7, in one embodiment, the treated component 103 is a heating, ventilation, air conditioning, and refrigeration system (HVAC&R system 701) or a portion of the HVAC&R system 701, such as, a vapor compression system 714, a boiler 716, an air return duct 718, an air supply duct 720, an air handler 722, heat exchange assemblies/components, or other suitable elements of the HVAC&R system 701.

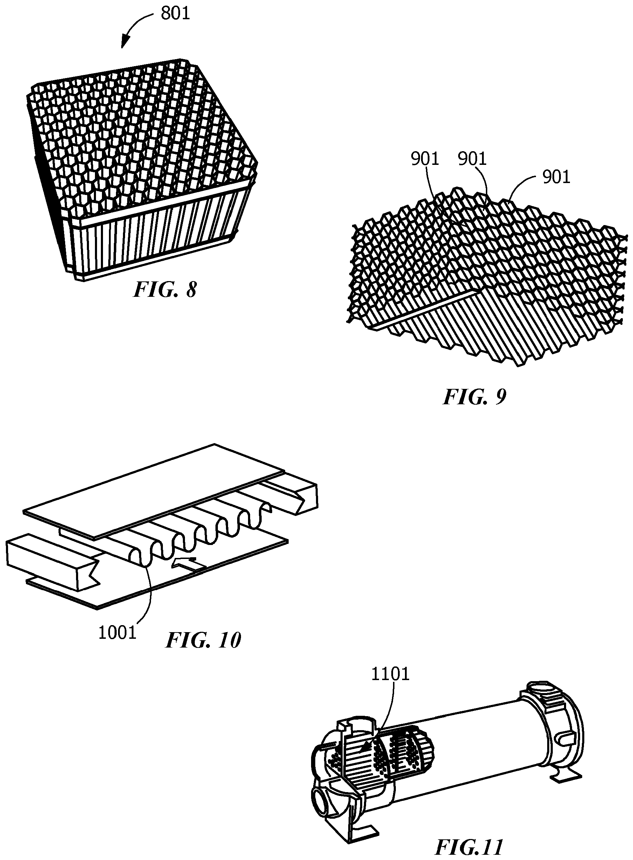

Referring to FIGS. 8-11, in one embodiment, the treated component 103 is a heat transfer system or a portion of the heat transfer system, such as, a heat exchanger, a cooler, or a chiller. Specific embodiments of the heat transfer system include, but are not limited to, a honeycomb arrangement 801 (see FIG. 8), one or more stacked plates 901 (see FIG. 9), one or more of fins 1001 (see FIG. 10), or a tube bundle 1101 (see FIG. 11). In other embodiments, the honeycomb arrangement 801, the stacked plate(s) 901, the fin(s) 1001, and/or the tube bundle 1101 are a portion of a different system (not shown) or are stand-alone components for future assembly within the heat transfer system or the different system (not shown).

While the invention has been described with reference to one or more embodiments, it will be understood by those skilled in the art that various changes may be made and equivalents may be substituted for elements thereof without departing from the scope of the invention. In addition, many modifications may be made to adapt a particular situation or material to the teachings of the invention without departing from the essential scope thereof. Therefore, it is intended that the invention not be limited to the particular embodiment disclosed as the best mode contemplated for carrying out this invention, but that the invention will include all embodiments falling within the scope of the appended claims. In addition, all numerical values identified in the detailed description shall be interpreted as though the precise and approximate values are both expressly identified. All compositions shall be understood as potentially having incidental impurities, for example, that do not affect performance of such compositions.

## Claims

1. A treated article, comprising:
a metal or metallic substrate;
a treated surface of the metal or metallic substrate, the treated surface having fluorine, silicon, and carbon within the metal or metallic substrate, wherein the treated surface is produced by exposure of the metal or metallic substrate to an organofluorotrialkoxysilane and/or an organofluorosilylhydride and/or an organofluoro silyl and/or tridecafluoro 1,1,2,2-tetrahydrooctylsilane,, **characterized in that**
-- the metal or metallic substrate is 304 stainless steel, wherein the treated surface has a water contact angle within the range of between 120° and 121° and a hexadecane contact angle within the range of between 77° and 78° prior to the thermal oxidation and wherein the water contact angle stays within a range of between 120° and 133° and the hexadecane contact angle stays within a range of between 77° and 81° during a thermal oxidation at 300°C in air over a period of up to 70 hours, or
-- the metal or metallic substrate is 316 stainless steel, wherein the treated surface has a water contact angle within the range of between 125° and 126° and a hexadecane contact angle within the range of between 75° and 76° prior to thermal oxidation and wherein the water contact angle stays within a range of between 125° and 135° and the hexadecane contact angle stays within a range of between 75° and 85° during a thermal oxidation at 300°C in air over a period of up to 70 hours.

2. The treated article of claim 1, wherein the treated article is a portion of one or both of an intake system and an exhaust system.

3. The treated article of claim 1, wherein the treated article is a portion of a fuel injection system.

4. The treated article of claim 1, wherein the treated article is a portion of a combustion system.

5. The treated article of claim 1, wherein the treated article is a portion of heat transfer system.

## Patentansprüche

1. Behandelter Artikel, umfassend:
ein Metall oder Metallsubstrat;
eine behandelte Oberfläche des Metalls oder Metallsubstrats, wobei die behandelte Oberfläche Fluor, Silicium und Kohlenstoff innerhalb des Metalls oder Metallsubstrats aufweist, wobei die behandelte Oberfläche erzeugt wird, indem das Metall oder Metallsubstrat einem Organofluortrialkoxysilan und/oder einem Organofluorsilylhydrid und/oder einem Organofluorosilyl und/oder Tridecafluoro-1,1,2,2-tetrahydrooctylsilan ausgesetzt wird,
**dadurch gekennzeichnet, dass**
-- das Metall oder Metallsubstrat Edelstahl 304 ist, wobei
die behandelte Oberfläche vor der thermischen Oxidation einen Wasserkontaktwinkel im Bereich zwischen 120° und 121° und einen Hexadecan-Kontaktwinkel im Bereich zwischen 77° und 78° aufweist und wobei
der Wasserkontaktwinkel während einer thermischen Oxidation bei 300 °C in Luft über einen Zeitraum von bis zu 70 Stunden innerhalb eines Bereichs zwischen 120° und 133° bleibt und der Hexadecan-Kontaktwinkel innerhalb eines Bereichs zwischen 77° und 81° bleibt,
oder
-- das Metall oder Metallsubstrat Edelstahl 316 ist, wobei
die behandelte Oberfläche vor der thermischen Oxidation einen Wasserkontaktwinkel im Bereich zwischen 125° und 126° und einen Hexadecan-Kontaktwinkel im Bereich zwischen 75° und 76° aufweist und wobei
der Wasserkontaktwinkel während einer thermischen Oxidation bei 300°C in Luft über einen Zeitraum von bis zu 70 Stunden innerhalb eines Bereichs zwischen 125° und 135° bleibt und der Hexadecan-Kontaktwinkel innerhalb eines Bereichs zwischen 75° und 85° bleibt.

2. Behandelter Artikel nach Anspruch 1, wobei der behandelte Artikel ein Teil eines Ansaugsystems oder eines Abgassystems oder beides ist.

3. Behandelter Artikel nach Anspruch 1, wobei der behandelte Artikel ein Teil eines Kraftstoffeinspritzsystems ist.

4. Behandelter Artikel nach Anspruch 1, wobei der behandelte Artikel ein Teil eines Verbrennungssystems ist.

5. Behandelter Artikel nach Anspruch 1, wobei der behandelte Artikel ein Teil eines Wärmeübertragungssystems ist.

## Revendications

1. Article traité, comprenant : un métal ou un substrat métallique ;
une surface traitée du métal ou du substrat métallique, la surface traitée contenant du fluor, du silicium et du carbone à l'intérieur du métal ou du substrat métallique, la surface traitée étant produite par exposition du métal ou du substrat métallique à un organofluorotrialcoxysilane et/ou un organofluorosilylhydrure et /ou un organofluorosilyle et/ou un tridécafluoro 1,1,2,2-tétrahydrooctylsilane, **caractérisé en ce que**
- le métal ou le substrat métallique est en acier inoxydable 304,
la surface traitée présentant un angle de contact avec l'eau compris entre 120° et 121° et un angle de contact hexadécane compris entre 77⁰ et 78⁰ avant l'oxydation thermique et dans lequel
l'angle de contact avec l'eau reste dans une plage comprise entre 120° et 133° et l'angle de contact avec l'hexadécane reste dans une plage comprise entre 77° et 81 (au cours d'une oxydation thermique à 300° C dans l'air sur une période de jusqu'à 70 heures, ou - le métal ou le substrat métallique est en acier inoxydable 316, la surface traitée présentant un angle de contact avec l'eau compris entre 125° et 126° et un angle de contact avec l'hexadécane compris entre 75° et 76° avant l'oxydation thermique et dans lequel l'angle de contact avec l'eau reste dans une plage comprise entre 125° et 135° et l'angle de contact avec l'hexadécane reste dans une plage comprise entre 75° et 85° pendant une oxydation thermique à 300°C dans l'air sur une période allant jusqu'à 70 heures.

2. Article traité selon la revendication 1, dans lequel l'article traité est une partie d'un ou des deux systèmes d'admission et d'échappement.

3. Article traité selon la revendication 1, dans lequel l'article traité fait partie d'un système d'injection de carburant.

4. Article traité selon la revendication 1, dans lequel l'article traité est une partie d'un système de combustion.

5. Article traité selon la revendication 1, dans lequel l'article traité est une partie du système de transfert de chaleur.
